(19)

Europäisches
Patentamt
European
Patent Office
Office européen
des brevets

(11) **EP 2 110 753 A1**

(12) **EUROPEAN PATENT APPLICATION**

(43) Date of publication:
**21.10.2009 Bulletin 2009/43**

(51) Int Cl.:
*G06F 13/16* (2006.01)   *G11C 7/10* (2006.01)
*G11C 16/10* (2006.01)

(21) Application number: **08154473.6**

(22) Date of filing: **14.04.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(71) Applicant: **Deutsche Thomson OHG
30625 Hannover (DE)**

(72) Inventor: **Winter, Marco
30659 Hannover (DE)**

(74) Representative: **Rittner, Karsten
Deutsche Thomson OHG
European Patent Operations
Karl-Wiechert-Allee 74
30625 Hannover (DE)**

(54) **Method for storing an object in a storage device**

(57)     The invention is related to a method for storing an object in a storage device.

Said method comprises receiving object data from a data stream, buffering the object data in a first buffer area and transferring the object data to a storage device. The inventive method further comprises that the amount of object data buffered corresponds in size to one standard portion being sized such that the time difference between the time required for transferring one standard portion to the storage device and the time required for receiving one standard portion approximates but does not exceed a reception time required for receiving the object.

A first portion of a subsequent object can be stored in said first buffer area since the last data of the first portion of said object is transferred to the storage device before receiving the last data of the first portion of said subsequent object.

Fig. 2

**Description**

Background

The invention is related to a method for storing an object in a storage device. More precisely, the invention is related to method for storing an object received as part of a sequence of equally sized objects comprised in a data stream.

Digital video cameras capture frames at a frame rate and with a frame resolution by help of an image capturing device being for instance a complementary metal-oxide semiconductor (CMOS) or a charge coupled device (CCD). The frame rate and the frame resolution result in a capture data rate.

For professional applications, frame rate and resolution need to be high. So, the capture data rate of professional video equipment is high as well.

Captured frames need to be stored. For storage in real-time, the storage data rate has to meet the capture data rate. But, commonly used slow memorizing devices like flash memories do have storage data rates which are significantly lower than said high capture data rate resulting in professional applications.

Therefore, a memory array comprising several flash memories is used. The flash memories in the memory array are provided with data in parallel. So, the storage data rate of the memory array equals the cumulated storage data rates of the flash memories comprised in said memory array. The ratio of the video camera's capture data rate to a single flash memory's storage rate gives the minimal number $N$ of flash memories which need to be comprised in the memory array for ensuring that the memory array's storage data rate meets the video camera's capture data rate.

For synchronizing purposes the flash memory array is connected to the video camera's image capturing device via a buffer, for instance a dynamic random access memory (DRAM).

Flash memories are organized in memory blocks. If some data in a given memory block shall be changed, even data remaining unchanged but being comprised in said given memory block needs to be re-written.

Therefore, European Patent Application EP07121847 proposes a storing method which ensures that, after transferring to a first flash memory a first fraction of a first frame, only fractions of said first frame are transferred to said first flash memory until the amount of data belonging to said first frame and being transferred to said first flash memory corresponds to the storage capacity of at least one memory block.

To achieve this while keeping buffer control simple, European Patent Application EP07121847 proposes a large buffer having enough storage capacity for $N$ memory blocks with one memory block sized buffer area assigned to each of the flash memories. This approach is optimized towards most simple control.

European Patent Application EP07121847 further illustrates an example with a complex buffer control wherein a buffer having a buffering capacity of 1.5 memory blocks is sufficient for a scenario wherein N equals four.

There is a need for a storing method being simple in control while operating at a reasonable buffer size.

Invention

This is achieved by a method for storing an object in a storage device, said method comprising the features of claim 1.

Said method comprises the steps of receiving object data from a data stream, buffering the object data in a first buffer area and transferring the object data to a storage device. The inventive method further comprises that the amount of object data buffered corresponds in size to one standard portion being sized such that the time difference between the time required for transferring one standard portion to the storage device and the time required for receiving one standard portion approximates but does not exceed a reception time required for receiving the object.

Then, a first standard portion sized data amount of an adjacently subsequent object can be stored in said first buffer area as it is ensured that the very last data of the first standard portion sized data amount of said object is already transferred from the first buffer area to the storage device before the very last data of the first standard portion sized data amount of said adjacently subsequent object is received.

In a further embodiment, the method further comprises receiving further object data corresponding to one standard portion in size, buffering the further object data in a separate second buffer area being by the size of one standard portion larger than the first buffer area and transferring the further object data to the storage device.

The larger size of the second buffer area capable of storing at least two standard portions reflects the longer time second standard portions of objects resides in the buffer. That is, transfer of the second standard portion of said object to the storage device begins at the same time as reception of a second standard portion of said adjacently subsequent object. The second standard portion of said adjacently subsequent object is therefore buffered in the part of the second buffer area which was not used for buffering said second standard portion of said object. A second standard portion of another object adjacent to said adjacently subsequent object then may be buffered in the part of the second buffer area which temporarily buffered the data of said second standard portion of the object.

In yet a further embodiment, the object is received in $n$ equally sized object data portions each corresponding to one standard portion in size, the buffer comprises $0.5*n(n+1)$ buffer locations, each being capable of storing one standard portion, and the $k$-th object data portion (k=1,2,...,n) is buffered in a buffer range of $k$ buffer locations said buffer range starting with the $(0.5*(k-1)*k+1)$-th buffer location which is included in the range and ranging to the $(0.5*k*(k+1))$-th buffer location which is also included in the range.

In even yet a further embodiment, said object is received as part of a sequence of equally sized objects comprised in said data stream, wherein the $k$-th object data portion of the $l$-th object (l=x+1,x+2,... ) is buffered in the $((0.5*(k-1)*k)+mod(l-1,k)+1)$-th buffer location wherein x may be an arbitrarily selectable constant integer offset which does not affect the quality of the buffering process.

Within said even yet a further embodiment a buffering capacity of 0.5*N*(N-1) standard portions is sufficient. This equals the data amount of 0.5*N memory blocks.

There is another embodiment, wherein, after transferring said object to said storage device, data of subsequent n objects are transferred to at least another independently accessible storage device.

In yet another embodiment, said sequence of objects is a frame sequence, said storage device comprises at least one flash memory comprising one or more memory blocks, said at least another independently accessible storage device comprises $n$ further flash memories comprising further memory blocks, an object is formed from a frame portion having the size of a memory block and each of the subsequent $n$ objects is transferred to one of the $n$ further flash memories.

The invention is further related to a device for storing a frame sequence, comprising a plurality of memory devices and an interleaver adapted for receiving the data stream in data portions, wherein each of the memory devices is provided with a slice of an output data portion outputted by the interleaver.

In an embodiment of the device the data stream is received at a first data rate, each of the memory devices operate at the same second data rate, the number $N$ of memory devices meets or exceeds the first data rate to second data rate ratio and the interleaver is a $(N-1,N-1)$-interleaver.

Further inventive aspects are apparent from the drawings, the description and the claims.

Drawings

Exemplary embodiments of the invention are illustrated in the drawings and are explained in more detail in the following description.

In the figures:

Fig. 1   shows an example of the prior-art system architecture for real-time storage to a memory array,

Fig. 2   depicts a first example of the inventive system architecture for real-time storage to a memory array,

Fig. 3   depicts a second example of the inventive system architecture for real-time storage to a memory array,

Fig. 4   depicts a third example of the inventive system architecture for real-time storage to a memory array,

Fig. 5   depicts a fourth example of the inventive system architecture for real-time storage to a memory array,

Fig. 6   depicts a fifth example of the inventive system architecture for real-time storage to a memory array and

Fig. 7   depicts a sixth example of the inventive system architecture for real-time storage to a memory array.

Exemplary embodiments

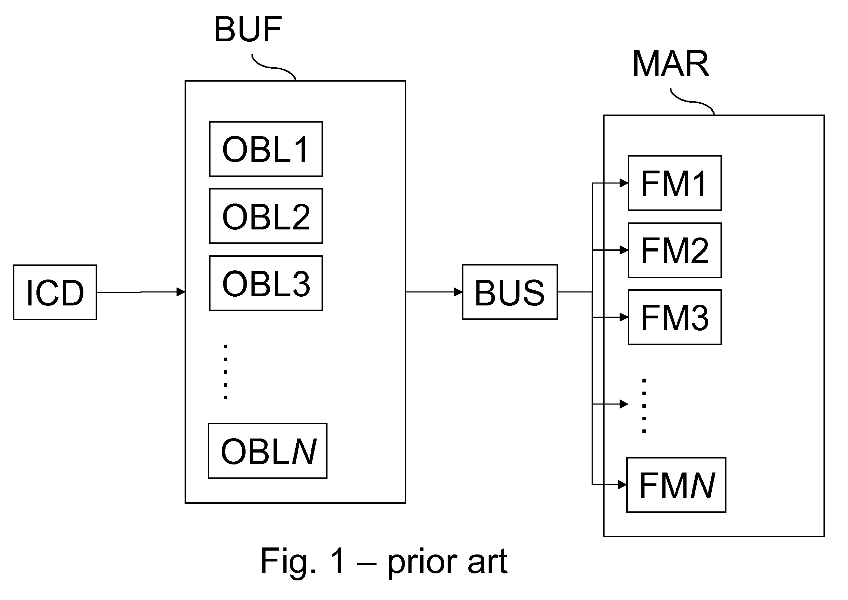

Figure 1 depicts the way frame sequences are stored according to the prior art. An image capturing device ICD like a CMOS-sensor or a CCD-sensor captures frames as bitmaps with a given frame rate. This results in a capturing data rate $R_{cap}$.

Captured images are forwarded to a buffer BUF, for example an SDRAM. The buffer comprises $N$ buffer locations OBL1, OBL2, OBL3 ... OBLN, wherein each of the buffer locations OBL1, OBL2, OBL3 ... OBLN is capable of buffering a memory block sized data object. A bus BUS transfers data from the buffer BUF to a memory array MAR. The memory array MAR comprises $n$ flash memories FM1, FM2, FM3 ... FMN. Data transfer is arranged such that flash memory FM$x$, with $x = 1, 2, ..., N-1$ or $N,$ is provided with data buffered in buffer location OBL$x$, only.

The bus BUS operates at a bus rate determined by a clock cycle and is capable of carrying a data amount per clock cycle. This results in a bus data rate $R_{bus}$. The bus data rate $R_{bus}$ equals or exceeds the capture data rate $R_{cap}$ in order to avoid buffer overflow.

Each of the $N$ flash memories FM1, FM2, FM3 ... FM$N$ operates at a flash storage data rate $R_{stor}$. The flash storage data rate $R_{stor}$ is much lower than capture data rate $R_{cap}$. The number $N$ of flash memories FM1, FM2, FM3 ... FM$N$ in memory array MAR is chosen such that $N* R_{stor}$ is equal to or larger than the capture data rate $R_{cap}$. So, the storage data rate of the memory array MAR in its entirety is equal to or larger than the capture data rate $R_{cap}$. This enables real-time recording.

In each clock cycle, the bus BUS transfers a data packet from the buffer BUF to the memory array MAR. The data packet is partitioned into $N$ slices of equal data amount. Each of the slices is filled with data from one of the $N$ object buffer locations OBL1, OBL2, OBL3 ... OBLN. Each of the $N$ flash memories FM1, FM2, FM3 ... FMN is provided with one of the slices. As the ratio of the data amount of one slice to clock cycle time is smaller than or equal to the flash storage rate, the $N$ flash memories FM1, FM2, FM3 ... FMN are able to store the data packet before a next data packet is delivered by the bus BUS.

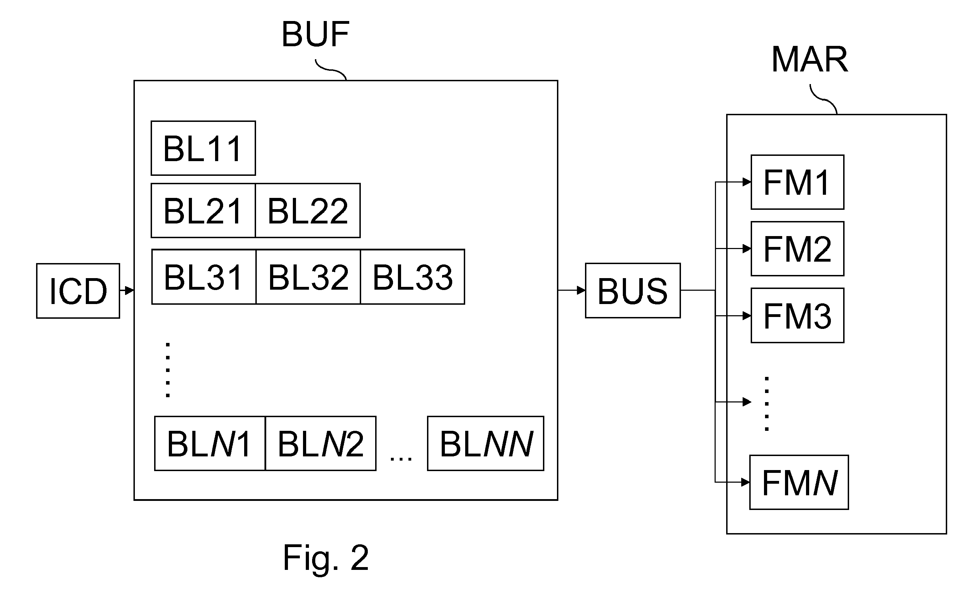

Fig. 2 depicts a first example of inventive system architecture for real-time storage to a memory array according to the invention. Let $n$ equal $N-1$. In comparison with fig. 1, the buffer comprises $N*(N-1)/2$ buffer location BL11, BL12, BL22, BL13 ... BL$nn$, but said buffer locations are much smaller than the object buffer locations OBL2, OBL3 ... OBLN known from prior art. That is, each of said buffer location BL11, BL12, BL22, BL13 ... BL$nn$ has a buffering capacity equalling the storage capacity of a memory block divided by $n$. The buffer size required for the invention equals the data amount of $N/2$ memory blocks while the prior art required a buffering capacity for the data amount of $N$ memory blocks.

As in the prior art, the bus BUS transfers a data packet from the buffer BUF to the memory array MAR in each clock cycle. The data packet is partitioned into $N$ slices of equal data amount. Each of slices is filled with data from one of the $0.5*N*(N-1)$ buffer locations BL11, BL21, BL22, BL31 ... BLnn and each of the $N$ flash memories FM1, FM2, FM3 ... FM$N$ is provided with one of the slices.

But the buffer locations BL11, BL21, BL22, BL31 ... BLnn from which data is filled into the slices change in each clock cycle. To be more precisely, one of the buffer locations BL11, BL21, BL22, BL31 ... BLnn from which data is filled into the slices changes in each clock cycle.

The invention is based on the idea of taking advantage of different write time durations for the parts of a frame. Each frame is separated in parts called fragments, segments or data portions below. The contiguous fragments or data portions of a single frame are all of the same size.

The fragment size $D_F$ of the same-sized portions is chosen in a way, that the time $T_{SF}$ needed for transferring one standard portion to the flash memory approximates, best meets, but does not exceed the sum of the time $T_{RO}$ needed for receiving a data amount $D_O$ corresponding to one object of the size of a memory block and the time $t_0$ needed for receiving one fragment. With $R_{cap}$ being the capture data rate, $R_{stor}$ being the storage data rate of a single flash memory, $N= R_{cap}/R_{stor}$ and $n=N-1$ the standard fragment size $D_F$ can be determined as

$$D_F = \frac{D_O * R_{stor}}{R_{cap} - R_{stor}} = \frac{D_O}{n} \qquad (1)$$

Thus, the reception time $T_{RO}$ required for receiving one object of the size of a memory block equals $n*t_0$. And the buffering capacity of each of the buffer locations is sufficient for buffering one of the fragments or data portions.

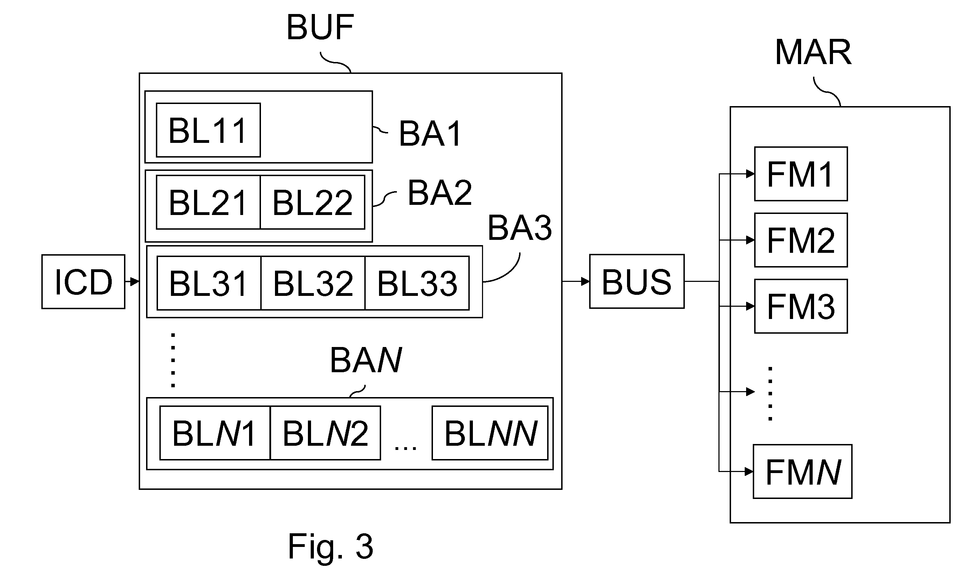

The fragments are stored in the buffer locations BL11, BL21, BL22, BL31 ... BLnn comprised in a buffer BUF. As exemplarily depicted in figure 3, said buffer BUF may comprise $0.5*N*n$ buffer locations BL11, BL21, BL22, BL31 ... BLnn virtually arranged in $n$ buffer areas BA1, BA2, BA3, ... BAn comprising increasing numbers of buffer locations. That is, the first buffer area BA1 comprises a single buffer location BL11, the second buffer area BA2 comprises two buffer locations BL21 and BL22, the third buffer area BA3 comprises three buffer locations BL31, BL32 and BL33 and so on till the $n$-th buffer area BAn which comprises $n$ buffer locations BL$n$1, ... BL$nn$.

After spending some time at a buffer location BL11, BL21, BL22, BL31 ... BL$nn$, a fragment is transferred by the bus BUS to one of flash memories FM1, FM2, FM3 ... FMN comprised in an array of $N$ flash memories MAR. To which of the flash memories a given fragment is transferred depends on the object to which the given fragment belongs. The time during which the given fragment resides in the buffer depends on its position in the object.

That is, reception of $k$-th standard portion of the $l$-th object starts at time $(n*(l-1)+(k-1))*t_0$ and is terminated at time $((n*(l-1)+k)*t_0$. Transfer of said $k$-th standard portion of the $l$-th object starts at time $(n*(l-1)+N*(k-1))*t_0$. Transfer is terminated at time $((n*(l-1)+N*k)*t_0$.

At time step $t=z*t_0$, parameters $r, r'$ and $s$ can be determined by help of adjuvant parameters $p$ and $q$ as follows:

$$p(z) = \mathrm{mod}(z-1, n) + 1 \tag{1}$$

$$q(z) = \frac{(z - N*(p-1))}{n} \tag{2}$$

$$r(z) = \mathrm{mod}(q(z), p(z)) + 1 \tag{3}$$

$$r'(z) = \begin{cases} p(z) & \text{if} \quad q(z) = p(z) \\ r(z) - 1 & \text{otherwise}. \end{cases} \tag{4}$$

$$s(z) = \mathrm{mod}(q(z) - 1, N) + 1 \tag{5}$$

wherein $mod(x,y)$ denotes $x$ modulo $y$.

So, at time $t=z*t_0$, data transfer from the $r(z)$-th buffer location of the $p(z)$-th buffer area to the $s(z)$-th flash memory is started and data reception at buffer location $r'(z)$ of said $p(z)$-th buffer area is started. That is a write pointer is moved from buffer location $r'(z-1)$ of buffer area $p(z-1)$ to the $r'(z)$-th buffer location of said $p(z)$-th buffer area. For $z$ smaller or equal to $N$, a read pointer at the $r(z)$-th buffer location of the $p(z)$-th buffer area is initialized in each time step. And for $z>N$, a read pointer is moved from the $r(z-N)$-th buffer location of the $p(z-N)$-th buffer area to the $r(z)$-th buffer location of the $p(z)$-th buffer area.

Each of the read pointers is dedicated to one of the flash memories and allows for filling a corresponding slice of a buses data packet with data to-be-transferred to the flash memory to which the read pointer is dedicated.

The adjuvant parameters need not to be calculated but can be updated:

$$p(z+1) = \begin{cases} p(z) + 1 & \text{if} \quad p(z) < N - 1 \\ 1 & \text{otherwise}. \end{cases} \tag{6}$$

$$q(z+1) = \begin{cases} q(z) - 1 & \text{if} \quad p(z) < N - 1 \\ (z+1)/n & \text{otherwise}. \end{cases} \tag{7}$$

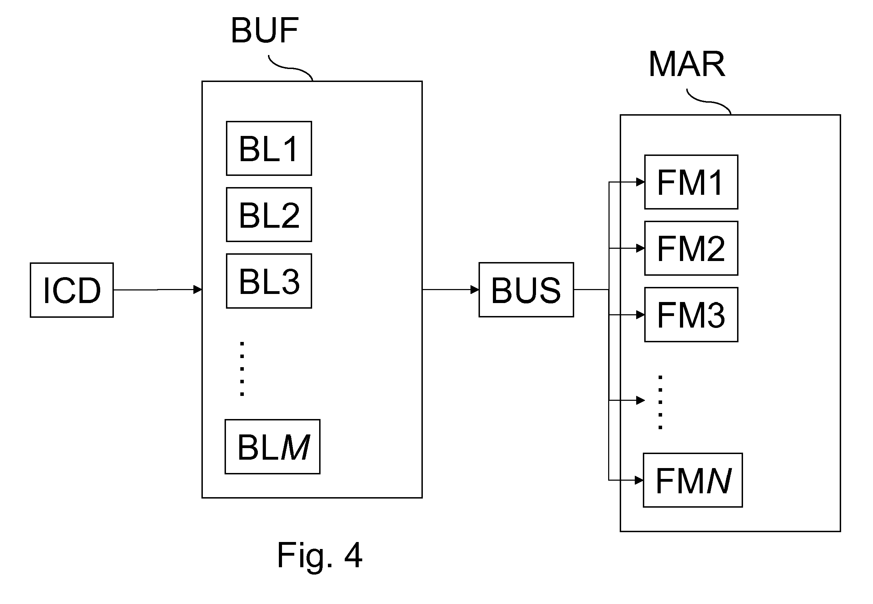

Exemplarily assumed that the buffer is not separated in buffer areas but simply comprises $M=0.5*N*n$ buffer locations BL1 ... BLM as depicted in figure 4, each capable of buffering one standard fragment. Then, at time $t=z*t_0$, data transfer from the $v$-th buffer location to the $s$-th flash memory is started and data reception at the $v'$-th buffer location is started wherein

$$v(z) = 0.5 * p(z) * (p(z) - 1) + \mathrm{mod}(q(z), p(z)) + 1 \qquad (8)$$

and

$$v'(z) = \begin{cases} 0.5 * p(z) * (p(z) + 1) & if \quad q(z) = p(z) \\ v(z) - 1 & otherwise. \end{cases} \qquad (9)$$

At each time step, data reception in a certain buffer location is started wherein reception at said certain buffer location is also terminated during said time step. So, maintenance of a single reception pointer for data reception is sufficient.

By contrast, a transfer to the flash memories started in a given time step will continue for the subsequent *N-1* time steps. As in each of said subsequent time steps a new transfer is started, at most *N* transfer pointers are involved in data transfer to the flash memories. The *N* pointer are distributed such that there is one pointer pointing to one buffer location in each buffer area wherein there is one buffer area comprising a second buffer location to which a pointer is pointing.

So a system having a data capture rate to flash storage data rate ratio of *N* requires a buffer being capable of storing a data amount corresponding to *0.5\*N\*(N-1)/(N-1)=N/2* memory blocks and has to maintain one pointer for reception and *N* pointers for transfer. The minimum amount of buffer which is empty at any time instance corresponds to half a memory block. In each time step, at least three parameters have to be calculated or updated, namely, *v, v'* and *s*, and two pointers -the reception pointer and one of the transfer pointers- have to be initialized and/or relocated.

That is, a write pointer is moved from buffer location *v'(z-1)* to the *v'(z)*-th buffer location. For z smaller or equal to *N*, a read pointer at the *v(z)*-th buffer location is initialized in each time step. And for *z>N*, a read pointer is moved from the *v(z-N)*-th buffer location to the *v(z)*-th buffer location.

Thus, the buffer acts as an interleaver and performs (*n,n*)-interleaving. No data portion of *n* data slices which is transferred to the flash memories contains any data slices that were separated by fewer than *n* data slices in the received data stream.

An (*n,n*)-interleaver is also a (*n,n*)-deinterleaver. Therefore, the interleaving buffer could further be used for retrieving the data stream from the flash memories.

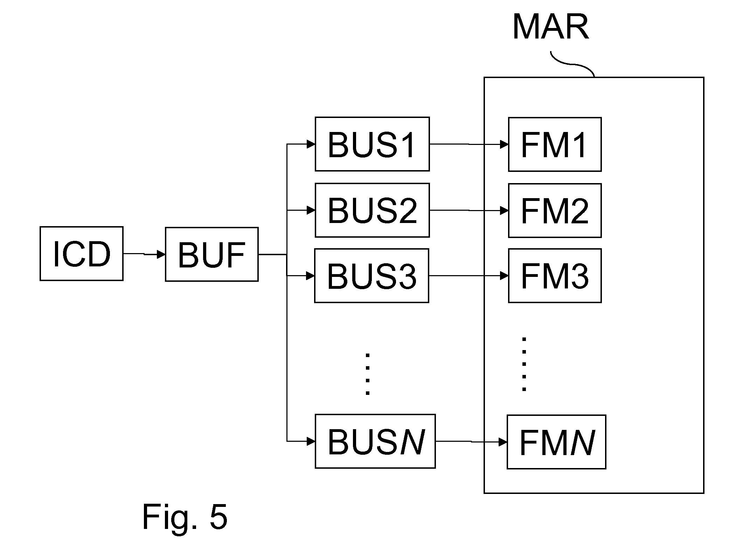

Fig. 5 exemplarily depicts another way of data transfer from the buffer BUF or from the interleaver to the memory device array. There are as many buses BUS1, BUS2, BUS3 ... BUSN as memory devices in the array wherein each of the buses exclusively transfers data to a single flash memory FM1, FM2, FM3 ... FM*N*.

Each of the buses BUS1, BUS2, BUS3 ... BUS*N* operates at a bus data rate equalling the storage data rate of the corresponding flash memory FM1, FM2, FM3 ... FM*N*. Each of the buses BUS1, BUS2, BUS3 ... BUSN is associated with one of the *N* read pointers for transfer. That is, each of the buses BUS1, BUS2, BUS3 ... BUSN is provided with data from the read pointer with which it is associated.

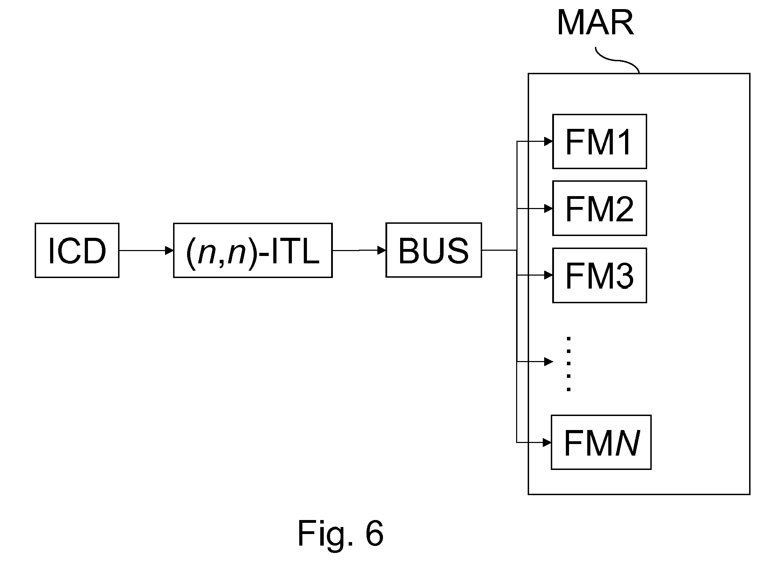

Fig. 6 exemplarily depicts a system capturing image data with image data capturing device ICD, interleaving the captured image data with (*n,n*)-interleaver (*n,n*)-ITL and storing the captured image data in an memory array MAR comprising *n+1=N* memorizing devices FM1, FM2, FM3 ... FM*N*, e.g. flash memories.

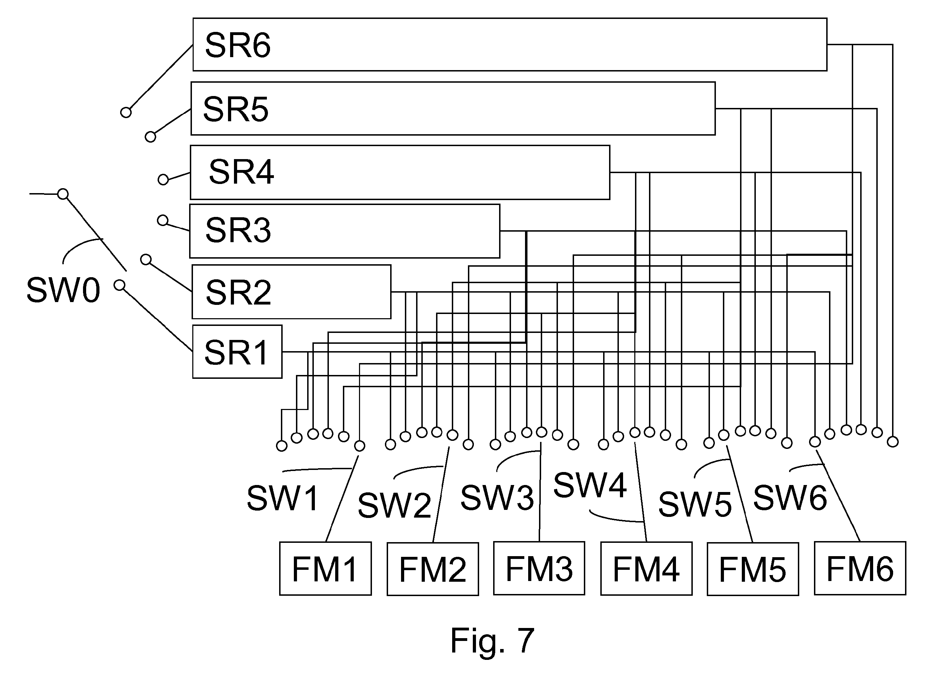

Said (*n,n*)-interleaver (*n,n*)-ITL is depicted in more detail in Fig. 7 for *n=6*. In each time step, a data amount corresponding to one fragment or data portion is forwarded by switch SW0 to one of six shift registers SR1, SR2, SR3, SR4, SR5, SR6 of increasing length. The six shift registers SR1, SR2, SR3, SR4, SR5, SR6 are first-in-first-out registers retarding the output of inputted data portion according the length of the shift register and requiring *n=6* times as long for outputting a data portion than for receiving it. That is, the first shift register SR1 starts outputting a data portion immediately after reception, the second shift register SR2 starts outputting a data portion *n=6* time steps after receiving it, the third shift register SR3 starts outputting a data portion *2\*n=12* time steps after receiving it and so on. At the beginning, the switch SW0 forwards a first data portion to the first shift register SR1. After *n=6* time steps the switch SW0 forwards another data portion to the first shift register SR1, again. Each of the shift registers SR1, SR2, SR3, SR4, SR5, SR6 has an output connected to *n=6* switches. Each of the switches is adapted for providing connections to anyone of the *n=6* flash memories FM1, FM2, FM3, FM4, FM5, FM6. The switches SW1, SW2, SW3, SW4, SW5, SW6 are switched every *n=6* time steps and are arranged such that each shift register is connected with one and only one of the flash memories. After *n=6* time steps the switches SW1, SW2, SW3, SW4, SW5, SW6 are switch such that the next larger shift register is connected with a given flash memory. If there is no such next larger shift register, the switch is switched to the first shift register again.

In a further embodiment, the fragment size $D'_F$ of the same-sized portions is chosen such that the time $T_{SF}$ needed for transferring one standard portion to the flash memory approximates, best meets, but does not exceed the sum of the time $T_{RO}$ needed for receiving a data amount $D_O$ corresponding to one object of the size of a memory block. Thus, the standard fragment size $D'_F$ can be determined as

$$D'_F = \frac{D_O * R_{stor}}{R_{cap}} = \frac{D_O}{N} \qquad (10)$$

Thus, given the reception time $T_{RO}$ required for receiving one object of the size of a memory block equals $N*t'_0$ wherein $t'_0$ denotes the time for receiving a standard portion of size $D'_F$.

The fragments are stored in the buffer locations BL11, BL21, BL22, BL31 ... BLNN comprised in a buffer BUF. Said buffer BUF may comprise $0.5*N*(N+1)$ buffer locations BL11, BL21, BL22, BL31 ... BLNN virtually arranged in $N$ buffer areas BA1, BA2, BA3, ... BAN comprising increasing numbers of buffer locations. That is, the first buffer area BA1 comprises a single buffer location BL11, the second buffer area BA2 comprises two buffer locations BL21 and BL22, the third buffer area BA3 comprises three buffer locations BL31, BL32 and BL33 and so on till the $N$-th buffer area BA$N$ which comprises $N$ buffer locations BLN1, ... BL$NN$.

After spending some time at a buffer location BL11, BL21, BL22, BL31 ... BL$NN$, a fragment is transferred by the bus BUS to one of flash memories FM1, FM2, FM3 ... FM$N+1$ comprised in an array of $N+1$ flash memories MAR. To which of the flash memories a given fragment is transferred depends on the object to which the given fragment belongs. The time during which the given fragment resides in the buffer depends on its position in the object.

Within said further embodiment, reception of $k$-th standard portion of the $1$-th object starts at time $(N^*(1-1)+k))$ $*t'_0$ and is terminated at time $((N^*(1-1)+k+1)*t'_0$. Transfer of said $k$-th standard portion of the $1$-th object starts at time $(N^*(l+k-2)+k)*t'_0$. Transfer of said $k$-th standard portion of the $l$-th object is terminated at the beginning of time step $((N^*(l+k-1)+k)*t'_0$.

There is one reception pointer being updated or relocated to another buffer location in each time step.

At time step $t=z*t'_0$, parameters $bl(z)$ and $ba(z)$ can be determined as follows:

$$ba(z) = \mathrm{mod}(z-1, N) + 1 = \begin{cases} ba(z-1)+1 & if\ ba(z-1) < N \\ 1 & otherwise. \end{cases} \qquad (11)$$

$$bl(z) = \mathrm{mod}(\frac{(z-ba(z))}{N}, ba(z)) + 1 \qquad (12)$$

That is, the reception pointer is moved from buffer location $bl(z-1)$ of buffer area $ba(z-1)$ to the $bl(z)$-th buffer location of said $ba(z)$-th buffer area.

Within the further exemplary embodiment, there are N transfer pointers wherein on each of the buffer areas BA1, BA2, BA3, ... BA$N$ one transfer pointer is operating. If the $k$-th transfer pointer reading data from the $k$-th buffer area reaches the end of the $k$-th buffer location BL$kk$ comprised in said $k$-th buffer area BUF$k$, said $k$-th pointer is relocated to the beginning of the first buffer location BL$k$1 in said $k$-th buffer area BUF$k$.

So, the transfer pointers are no longer associated with the memory devices FM1, FM2, FM3 ... FM$N+1$ in the memory area MAR but with the buffering areas BA1, BA2, BA3, ... BA$N$.

Therefore, it has to be determined in each time step, into which of $N+1$ data slices of the data packet on the bus (or into the data packet of which of the separated $N+1$ buses) data read by the $k$-th transfer pointer is packed.

The $k$-th transfer pointer is initialized as pointing to the beginning of the first buffer location BL$k$1 of $k$-th buffer area BA$k$ at the beginning of the $(N^*(k-1)+1)$-th time step and is used for putting data from said first buffer location BL$k$1 to first data slices of the data packets of the bus. Or, said $k$-th transfer pointer is used for putting data from said first buffer location BL$k$1 of $k$-th buffer area BA$k$ to the data packets of the first bus BUS1. This continues for the following N time steps. $N$ time steps later, that is at time step $(N^*k+1)$, the $k$-th transfer pointer starts putting data into second data slices of the data packets of the bus or into the data packets of the second bus BUS2. After putting data into *(N+1)*-th data slice of the data packets of the bus or into the data packets of the *(N+1)*-th bus BUS*N+1* for *N* time steps, that is at the *(N\*(N+k)+1)*-th time step, the transfer pointer is used for putting data into first data slices of the data packets of the bus or into the data packets of the first bus BUS1, again.

Per time step, there is one data slice remaining empty or one separate bus remaining idle. Every memory device in the array is confronted with such empty slice or idle bus every *N+1* time steps. As the data amount received within the intermediate N time steps corresponds to the data amount stored in one memory block the flash's idle time induced by the empty slice or the idle bus may be used advantageously for checking whether the data amount received within the intermediate N time steps before was stored correctly.

Within said further embodiment, a system having a data capture rate to flash storage data rate ratio of *N* requires a buffer being capable of storing a data amount corresponding to *0.5\*N\*(N+1)/N=(N+1)/2* memory blocks and has to maintain one pointer for reception and *N* pointers for transfer. The minimum amount of buffer which is empty at any time instance corresponds to one memory block.

For storage of frames corresponding in size to the storage capacity of *u* memory blocks, data of frames can be distributed equally over *u* memory devices while still ensuring that a memory block contains only data of a at most two frames. The size of data chunks or fragments can than be chosen much larger, because the chunks are transferred to *u* memory devices in parallel resulting in a transfer data rate being by factor *u* larger than $R_{stor}$.

$$D''_F = \frac{D_O * u * R_{stor}}{R_{cap} - u * R_{stor}} = (\frac{u}{N-u}) * D_O \qquad (14)$$

Then, the number of fragments per object is *(N/u)-1* and the number of buffer locations is *0.5\*((N/u)-1)\*(N/u)*. As each buffer location is capable of storing one chunk, the overall buffering capacity required corresponds to the storage capacity of *0.5\*(N/u)* memory blocks.

## Claims

1. Method for storing an object in a storage device (FM1), said method comprising the steps of

   - receiving object data from a data stream,
   - buffering the object data in a first buffer area (BA1) and
   - transferring the object data to a storage device (FM1),
   wherein
   - the amount of object data buffered corresponds in size to one standard portion being sized such that the time difference between the time required for transferring one standard portion to the storage device and the time required for receiving one standard portion approximates but does not exceed a reception time required for receiving the object.

2. Method according to claim 1, further comprising

   - receiving further object data corresponding to one standard portion in size,
   - buffering the further object data in a separate second buffer area (BA1, BA2, BA1 ... BAN) being by the size of one of the standard portions larger than the first buffer area and
   - transferring the further object data to the storage device (FM1).

3. Method according to claim 2, wherein

   - the object is received in *n* equally sized object data portions each corresponding to one standard portion in size,
   - the buffer comprises *0.5\*n(n+1)* buffer locations (BL11, BL21, BL22, BL31 ... BL*nn*), each being capable of storing one standard portion, and
   - the *k*-th object data portion is buffered in a buffer range of *k* buffer locations (BL*k*1, BL*k*2, BL*k*3 ... BL*kk*) said buffer range starting with the *(0.5\*(k-1)\*k+1)*-th buffer location (BL*k*1) which is included in the range and ranging to the *(0.5\*k\*(k+1))*-th buffer location (BL*kk*) which is also included in the range.

4. Method according to claim 3, wherein said object is received as part of a sequence of equally sized objects comprised in said data stream, wherein the $k$-th object data portion of the $l$-th object is buffered in the *((0.5\*(k-1)\*k)+mod(1-1,k) +1)*-th buffer location (BL11, BL21, BL22, BL31 ... BL$NN$).

5. Method according to claim 4, wherein, after transferring said object to said storage device (FM1), data of subsequent $n$ objects are transferred to at least another independently accessible storage device (FM2, FM3 ... FM$N$).

6. Method according to claim 5, wherein said sequence of objects is a frame sequence, said storage device comprises at least one flash memory (FM1) comprising one or more memory blocks, said at least another independently accessible storage device (FM2, FM3 ... FM$N$) comprises $n$ further flash memories comprising further memory blocks, an object is formed from a frame portion having the size of a memory block and each of the subsequent $n$ objects is transferred to one of the $n$ further flash memories (FM2, FM3 ... FM$N$).

7. Device for storing a frame sequence, comprising

   - a plurality of memory devices (FM1, FM2, FM3 ... FM$N$) and
   - an interleaver (($n,n$)-ITL) adapted for receiving the data stream in data portions, wherein
   - each of the memory devices is provided with a slice of an output data portion outputted by the interleaver (($n$, $n$)-ITL).

8. Device according to claim 7, wherein

   - the data stream is received at a first data rate,
   - each of the memory devices (FM1, FM2, FM3 ... FM$N$) operate at the same second data rate,
   - the number $N$ of memory devices (FM1, FM2, FM3 ... FM$N$) meets or exceeds the first data rate to second data rat ratio and
   - the interleaver (($n,n$)-ITL) is a ($N$-1,$N$-1)-interleaver.

Fig. 1 – prior art

Fig. 2

EP 2 110 753 A1

Fig. 3

EP 2 110 753 A1

Fig. 4

MAR

FM1 FM2 FM3 ..... FMN

BUS1 BUS2 BUS3 .... BUSN

BUF

ICD

Fig. 5

MAR

| FM1 | FM2 | FM3 | . . . . . | FMN |

BUS

$(n,n)$-ITL

ICD

Fig. 6

Fig. 7

Europäisches
Patentamt

European
Patent Office

Office européen
des brevets

**EUROPEAN SEARCH REPORT**

Application Number

EP 08 15 4473

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/048659 A1 (KANAMORI MOTOKI [JP] ET AL) 13 March 2003 (2003-03-13) <br> * the whole document * <br> ----- | 1-6 | INV. <br> G06F13/16 <br> G11C7/10 <br> G11C16/10 |
| | | | TECHNICAL FIELDS SEARCHED (IPC) |
| | | | G06F <br> G11C |

~~The present search report has been drawn up for all claims~~

| Place of search | Date of completion of the search | Examiner |
|---|---|---|
| Munich | 13 October 2008 | Ríos Báez, Abel |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt
European
Patent Office
Office européen
des brevets

Application Number

EP 08 15 4473

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-6

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

The Search Division considers that the present European patentapplication does not comply with the
requirements of unity of invention and relates to severalinventions or groups of inventions, namely:

1. claims: 1-6

   A method for storing an object in a storage. The amount of
   object data buffered is in correspondence with different
   transfer and storing times.
   ---

2. claims: 7,8

   A device for storing a frame sequence comprising memory
   devices and an interleaver.
   ---

EP 2 110 753 A1

## ANNEX TO THE EUROPEAN SEARCH REPORT
## ON EUROPEAN PATENT APPLICATION NO.

EP 08 15 4473

This annex lists the patent family members relating to the patent documents cited in the above-mentioned European search report.
The members are as contained in the European Patent Office EDP file on
The European Patent Office is in no way liable for these particulars which are merely given for the purpose of information.

13-10-2008

| Patent document cited in search report | Publication date | Patent family member(s) | Publication date |
|---|---|---|---|
| US 2003048659 A1 | 13-03-2003 | JP 3979486 B2<br>JP 2003085034 A | 19-09-2007<br>20-03-2003 |

EPO FORM P0459

For more details about this annex : see Official Journal of the European Patent Office, No. 12/82

20

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 07121847 A